Europäisches Patentamt

European Patent Office

Office européen des brevets

(11) Publication number: **0 275 540 B1**

## EUROPEAN PATENT SPECIFICATION

(45) Date of publication of patent specification: **18.11.93**

(51) Int. Cl.5: **H01L 29/64**, H01L 29/80, H01L 29/205

(21) Application number: **87119140.9**

(22) Date of filing: **23.12.87**

(54) **Staggered bandgap gate field effect transistor.**

(30) Priority: **20.01.87 US 5069**

(43) Date of publication of application:
**27.07.88 Bulletin 88/30**

(45) Publication of the grant of the patent:
**18.11.93 Bulletin 93/46**

(84) Designated Contracting States:
**DE FR GB**

(56) References cited:
**EP-A- 0 200 933**

**INTERNATIONAL ELECTRON DEVICES MEET-
ING, TECHNICAL DIGEST, Washington, DC,
1st-4th December 1985, pages 86-89, IEEE,
New York, US; Y. UMEMOTO et al.: "GaAs fet
with a degenerate semiconductor gate"**

**JAPANESE JOURNAL OF APPLIED PHYSICS;
SUPPLEMENTS (18TH INT. CONF. ON SOLID
STATE DEVICES AND MATERIALS, TOKYO
1986), 20th-22nd August 1986, pages 779-780,
Tokyo, JP; T. ITOH et al.: "AlxGa1-xAs hetero-
MIS gate depletion-mode InP FET's"**

(73) Proprietor: **International Business Machines
Corporation
Old Orchard Road
Armonk, N.Y. 10504(US)**

(72) Inventor: **Solomon, Paul Michael
2220 Brookside Avenue
Yorktown Heights New York 10598(US)**

(74) Representative: **Teufel, Fritz, Dipl.-Phys. et al
IBM Deutschland Informationssysteme
GmbH,
Patentwesen und Urheberrecht
D-70548 Stuttgart (DE)**

## Description

The technical field of the invention is in field effect transistors wherein a signal on a gate electrode modulates carrier flow in a channel region from a source to a drain electrode. In such devices, mobility and control advantages have been achieved when the field effect transistor is fabricated in all semiconductor material.

Advantages have been achieved in Field Effect Transistors using the physical properties of compound semiconductors. The use of a heterojunction between two compound semiconductors in the channel of an FET employed to enhance carrier mobility in that channel is shown in U.S. Patent 4,538,165; and the use of a higher bandgap semiconductor as the gate in an FET is shown in U.S. Patent 4,379,005.

The invention as claimed is to solve the problem of providing still better transconductance and drive capability of these transistor structures.

A more detailed description of the invention is given below with reference to drawings, in which:

FIG. 1    is an illustration of a staggered bandgap condition at an interface between two semiconductors.

FIG. 2    is an illustration of the field effect transistor of the invention having a gate of a   semiconductor material having a staggered bandgap with respect to the semiconductor of the channel.

FIG. 3    is an illustration of the band conditions in the "on" condition for the transistor of FIG. 2.

FIG. 4    is an illustration of the band conditions in the "off" condition for the transistor of FIG. 2.

In summary, the invention is a field effect transistor with a gate region selected with a semiconductor having the valence and conduction bands thereof staggered with respect to the valence and conduction bands of the semiconductor chosen for the channel of the field effect transistor.

The heterojunction formed by the staggered bandgap semiconductors exhibit adjacent accumulations of electrons and holes on the two sides of the gate channel interface. Transconductance in the channel region is enhanced by the fact that there is minimum separation between the gate and the channel region.

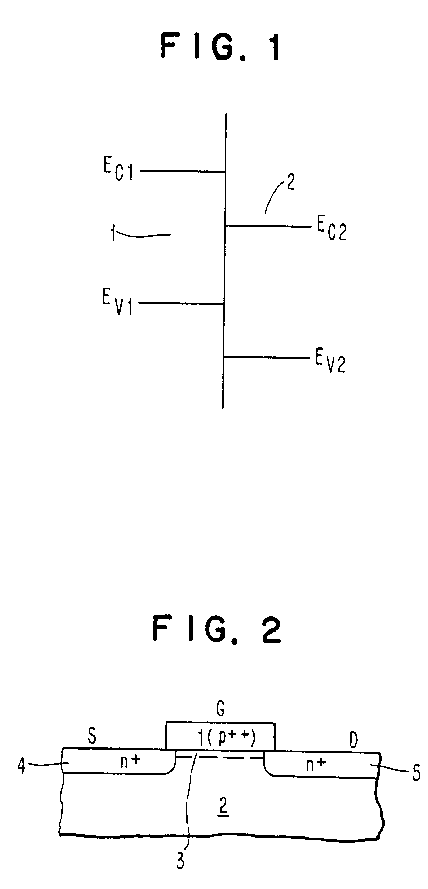

Referring to FIG. 1, a generalized energy band diagram of the semiconductors at the interface between the gate and the channel of the field effect transistor of the invention is shown. In FIG. 1, the semiconductor 1 which serves as the gate has the valence band thereof labelled $E_{V1}$ and the conduction band thereof labelled $E_{C1}$. Semiconductor 2 where the channel will be located has the valence band thereof labelled $E_{V2}$ and the conduction band thereof labelled $E_{C2}$. The bands are offset or staggered at the interface between the two semiconductors.

Referring next to FIG. 2, there is an illustration of the field effect transistor. In FIG. 2, a gate 1 of semiconductor 1 forms a heterojunction interface with a channel semiconductor 2 providing an inversion region 3 between source 4 and drain 5 heavily doped regions. The arbitrary designations of n and p conductivity type are employed.

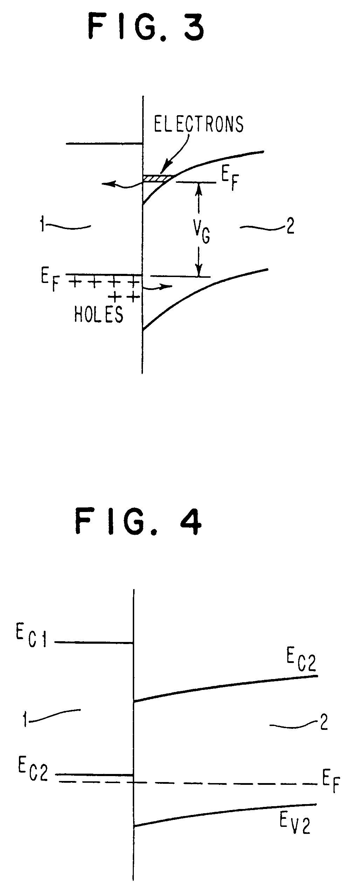

Referring next to FIG. 3, where band bending of the valence band of semiconductor 1 is considered minimal, in accordance with the invention, the gate 1 is very heavily doped, shown as $p^{++}$ and hence is highly conductive, and has little band bending so that most of the gate signal is applied to control of conduction in the channel. Under these conditions, the carriers, electrons in n conductivity type material in the inversion portion 3 of the channel semiconductor 2 are energetically opposite the forbidden gap of the gate semiconductor 1 and correspondingly the carriers, holes in p conductivity type material, in the gate semiconductor 1 are opposite the forbidden gap of the channel semiconductor 2. These conditions in a field effect transistor suppresses tunneling of carriers between the gate and the channel, permits the gate to be immediately adjacent the channel and improves transconductance without the penalty of gate leakage. The threshold voltage of the field effect transistor is determined only by the work function difference between the two semiconductors and hence is very reproducible.

In FIG. 3, the inversion layer 3 of FIG. 2 is formed under forward gate bias applied with a positive voltage between the gate 1 and the channel semiconductor 2.

Further in connection with FIG. 3, the electrons in the channel are energetically opposite the forbidden gap of the semiconductor 1 chosen to be the gate. Similarly, the holes in the semiconductor chosen to be the gate are opposite the forbidden gap of the semiconductor 2 chosen to be the channel. Thus, tunneling of electrons into the gate 1 from the channel 2 and holes into the channel 2 from the gate 1 is suppressed. This permits the highly conductive $p^{++}$ gate 1 to be thus immediately adjacent the channel 2 and inversion region 3 with no intervening insulator thereby providing, in accordance with the invention, a field effect transistor having maximum transconductance.

Gate current will result from recombination of electrons and holes but the current is much smaller than that of the channel current.

The field effect transistor of the invention under the off state conditions of no gate bias is illustrated by the band diagram of FIG. 4. A small field exists in the semiconductor 2. The field may be produced by either or both of two sources. If the semiconductor 2 is low conductivity p material, the source is acceptors. If the semiconductor 2 is semi-insulating, the source is carrier traps. Since the gate 1 is constructed to be more heavily doped than the channel 2 as shown in FIGS. 3 and 4, there is little band bending in the gate.

In accordance with the invention, the providing of a semiconductor gate 1 of a semiconductor material 1 with a staggered bandgap with respect to the bandgap of the semiconductor material chosen for the channel 2 has the advantage in a field effect transistor of providing the maximum transconductance in the channel. In such structures, transconductance is as described in Equation (1):

$$g_m = C_g \langle v \rangle \qquad (1)$$

where $C_g$ is the gate capacitance per unit area and $\langle v \rangle$ is the average velocity of the electrons in the channel.

In turn, the gate capacitance of most field effect transistors consists of the insulator capacitance $C_{ins}$ in series with the surface capacitance $C_{ss}$ of the semiconductor. This may be as expressed in Equation (2).

$$1/C_g = 1/C_{ins} + 1/C_{ss} \qquad (2)$$

where $C_{ins}$ is expressed as in Equation (3).

$$C_{ins} = E_{ins}/t_{ins} \qquad (3)$$

where $E_{ins}$ and $t_{ins}$ are the permittivity and thickness, respectively, of the gate insulator.

The expression of Equation (3) also applies to a Schottky barrier contact where $t_{ins}$ is the thickness of the band bending.

Under normal circumstances, the maximum transconductance obtainable with a given semiconductor would be when $t_{ins}$ was equal to zero, but this has not been achievable heretofore because of carrier interaction between the gate and the channel when the thickness of the insulator was too small.

In accordance with this invention, since there is no gate insulator or Schottky barrier, then the structure of this invention provides maximum transconductance because effectively it provides a structure in which $t_{ins}$ is equal to zero.

The preferred embodiment of the invention referring to FIGS. 2 and 3 would be one in which the channel semiconductor material 2 would be undoped or lightly doped p conductivity type InP and the gate semiconductor 1 would be heavily doped p type of the order of $10^{19}$ or more atoms/cm$^3$ of

AllnAs. The forward bias $V_G$ would be of the order of 0.3 volts between gate 1 and channel semiconductor.

What has been described is a field effect transistor principle providing better transconductance and drive capability by having a highly doped gate of opposite conductivity type of the channel, having the energy band of the semiconductor of the gate staggered with respect to that of the semiconductor of the channel so as to provide a barrier to both electrons and holes with respect to the interface.

**Claims**

1. A field effect transistor comprising in combination
   a first semiconductor material (2) member
      having source (4) and drain (5) regions separated by a channel region,
   a second semiconductor material gate (1) member of higher conductivity positioned contiguous with said channel,
   the band energy gap relationships of said first (2) and said second (1) semiconductor materials being offset so as to provide a barrier to a first type carrier entering said gate member from said channel and a barrier to the opposite type carrier entering said channel from said gate member.

2. The transistor of claim 1 wherein said gate semiconductor member is heavily doped.

3. The transistor of claims 1 or 2 wherein said gate semiconductor member is p$^{++}$ conductivity type.

4. The transistor of at least one of the preceding claims wherein said first semiconductor member is lightly doped p conductivity type InP and said second semiconductor gate member is heavily doped p conductivity type AllnAs.

5. The transistor of at least one of the preceding claims wherein
   the band energy gap relationships of said first (2) and said second (1) semiconductor materials being such at the interface between said first and second semiconductors that the valence and conduction bands of said first semiconductor are at a lower energy value than the valence and conduction band of said second semiconductor.

6. The transistor of at least one of the preceding claims wherein there is minimum separation between the gate and the channel region.

**Patentansprüche**

1. Feldeffekttransistor, der miteinander verbunden enthält
   einen ersten Halbleitermaterialbestandteil (2)
     mit Source-(4) und Drain-(5) Bereichen, die durch einen Kanalbereich getrennt sind,
   einen zweiten Halbleitermaterialbestandteil (1) als Gate mit höherer Leitfähigkeit, der an den Kanal angrenzend angebracht ist,
   wobei die Verhältnisse der Energiebandlücken des ersten (2) und zweiten (1) Halbleitermaterials gegeneinander versetzt sind, um eine Barriere für Ladungsträger eines ersten Typs zu liefern, die vom Kanal in den Gate-Bestandteil eindringen, und eine Barriere für die Ladungsträger des entgegengesetzten Typs zu liefern, die vom Gate-Bestandteil in den Kanal eindringen.

2. Transistor gemäß Anspruch 1, wobei der Gate-Halbleiterbestandteil stark dotiert ist.

3. Transistor gemäß der Ansprüche 1 oder 2, wobei der Gate-Halbleiterbestandteil vom $p^{++}$-Leitfähigkeitstyp ist.

4. Transistor gemäß zumindest einem der vorangegangenen Ansprüche, wobei der erste Halbleiterbestandteil leicht dotiertes InP vom p-Leitfähigkeitstyp und der zweite Halbleiterbestandteil für das Gate stark dotiertes AlInAs vom p-Leitfähigkeitstyp ist.

5. Transistor gemäß zumindest einem der vorangegangenen Ansprüche, wobei
   die Verhältnisse der Energiebandlücken des ersten (2) und zweiten (1) Halbleitermaterials an der Grenzfläche zwischen dem ersten und zweiten Halbleiter so sind, daß das Valenz- und Leitungsband des ersten Halbleiters eine geringere Energie haben als das Valenz- und Leitungsband des zweiten Halbleiters.

6. Transistor gemäß zumindest einem der vorangegangenen Ansprüche, wobei es eine minimale Trennung zwischen Gate- und Kanalzone gibt.

**Revendications**

1. Transistor à effet de champ comprenant en combinaison
   un premier élément en matériau semiconducteur (2)
     ayant des régions de source (4) et de drain (5) séparées par une région de canal,
   un second élément de grille en matériau semiconducteur (1) de conductivité supérieure, contigu audit canal,
   les relations de la bande d'énergie interdite entre ledit premier (2) et ledit second (1) matériaux semiconducteurs étant décalées de manière à obtenir une barrière pour un porteur du premier type entrant dans ledit élément de grille en provenance dudit canal et une barrière pour le porteur de type opposé entrant dans ledit canal en provenance dudit élément de grille.

2. Transistor selon la revendication 1 dans lequel ledit élément semiconducteur de grille est fortement dopé.

3. Transistor selon les revendications 1 ou 2 dans lequel ledit élément semiconducteur de grille est du type de conductivité p + + .

4. Transistor selon au moins l'une des revendications précédentes dans lequel ledit premier élément semiconducteur est d'un type de conductivité p légèrement dopé, InP, et ledit second élément semiconducteur de grille est d'un type de conductivité p fortement dopé, AlInAs.

5. Transistor selon au moins l'une des revendications précédentes dans lequel
   les relations de bande d'énergie interdite entre ledit premier (2) et ledit second (1) matériaux semiconducteurs sont telles qu'à l'interface entre lesdits premier et second semiconducteurs, les bandes de valence et de conduction dudit premier semiconducteur aient une valeur d'énergie inférieure aux bandes de valence et de conduction dudit second semiconducteur.

6. Transistor selon au moins l'une des revendications précédentes dans lequel il existe une séparation minimum entre la région de grille et la région de canal.

# F I G. 1

$E_{C1}$ ———

$E_{C2}$

$1$

$2$

$E_{V1}$ ———

$E_{V2}$

# F I G. 2

G

S    1( p++ )    D

4    n+    n+    5

2

3

# FIG. 3

# FIG. 4